# EUROPÄISCHE PATENTANMELDUNG

(11) **EP 4 362 237 A1**
(43) Veröffentlichungstag der Anmeldung: **01.05.2024**
(21) Anmeldenummer: 23203694.7
(22) Anmeldetag: 16.10.2023
(51) Int. Cl.: H01R 13/533

(54) **KONTAKTBAUGRUPPE FÜR EINEN ELEKTRISCHEN STECKVERBINDER MIT EINEM AN EINER LASTLEITUNG ANGEORDNETEN WÄRMEKAPAZITÄTSELEMENT**

(30) Priorität: 24.10.2022 BE 202205857
(71) Anmelder: Phoenix Contact e-Mobility GmbH, 32816 Schieder-Schwalenberg (DE)
(72) Erfinder: FÜHRER, Thomas, 32825 Blomberg (DE)
(74) Vertreter: Meyer-Graefe, Karsten

(57) **Zusammenfassung**

Eine Kontaktbaugruppe für einen elektrischen Steckverbinder (100), aufweisend: zumindest ein Kontaktelement (3, 3') mit einem ersten Endbereich (31, 31'), der zum Verbinden mit einem korrespondierenden Steckverbinder ausgebildet ist und einem dem ersten Endbereich (31, 31') abgewandten zweiten Endbereich (33, 33`);
eine Lastleitung (2, 2'), wobei ein Endabschnitt eines isolierhüllenfreien Bereichs (21, 21') der Lastleitung (2, 2') verbindbar ist mit dem zweiten Endbereich (33, 33`) des zumindest einen Kontaktelements (3, 3`); und
ein Wärmekapazitätselement (7, 7`), das zumindest bereichsweise an dem isolierhüllenfreien Bereich (21, 21') der Lastleitung (2, 2') anordenbar ist. Weiterhin schlägt die Erfindung einen elektrischer Steckverbinder, insbesondere einen Ladesteckverbinder einer Ladeeinrichtung zum Laden eines Elektrofahrzeugs vor.

## Beschreibung

Die Erfindung betrifft eine Kontaktbaugruppe für einen elektrischen Steckverbinder und einen elektrischen Steckverbinder, insbesondere einen Ladesteckverbinder einer Ladeeinrichtung zum Laden eines Elektrofahrzeugs.

Eine derartige Kontaktbaugruppe für einen elektrischen Steckverbinder weist zumindest ein Kontaktelement mit einem ersten Endbereich auf, der zum Verbinden mit einem korrespondierenden Steckverbinder ausgebildet ist und einem dem ersten Endbereich abgewandten zweiten Endbereich. Die Kontaktbaugruppe weist eine Lastleitung auf, wobei ein Endabschnitt eines isolierhüllenfreien Bereichs der Lastleitung verbindbar ist mit dem zweiten Endbereich des zumindest einen Kontaktelements.

Insbesondere im Bereich der E-Mobilität bestehen für Steckverbinder und damit verbundene Leitungssätze hohe Anforderungen hinsichtlich der Stromtragfähigkeit und der damit verbundenen thermischen Belastungen. Neben den Kabeln sind die Steckverbinder regelmäßig hohen Ladeströmen, z.B. von 800 Ampere und mehr ausgesetzt. Diese hohen Ströme sollen mit möglichst geringer Verlustleistung übertragen werden. Die Verlustleistung steigt quadratisch mit dem Strom.

Für ein Schnellladen mit Gleichstrom betragen die Ladezeiten oftmals zwischen 10 und 30 Minuten, wobei sich diese Ladezeiten zukünftig weiter verkürzen sollen. Die Aufheizkurven sind aufgrund der großen Massen der stromführenden Teile derart ausgeprägt, dass sich die Gleichgewichtstemperatur auch bei höheren Strömen teilweise erst nach mehreren Minuten einstellt. Normativ ist hierzu festgelegt, dass zu jedem Zeitpunkt des Ladens kein Bauteil innerhalb der Steckverbindung eine Temperaturerhöhung von mehr als 50 Kelvin erfahren darf. Wegen der normativen Definition der Steckverbinder im Bereich der E-Mobilität, ist es nicht möglich die Geometrien der Kontaktelemente zu skalieren, um damit eine größere Stromtragfähigkeit und eine geringere Temperaturerhöhung zu realisieren. Vielmehr soll mit den bestehenden genormten Steckverbinder-Geometrien größtmögliche Leistungsübertragungen erreicht werden und gleichzeitig die entstehende Stromwärme im Steckverbinder kontrollierbar gemacht werden.

Dies wird bislang oft erfolgreich mit aktiv gekühlten Steckverbindern und Ladekabeln erreicht. Der technische Aufwand, der hierfür in der Regel betrieben werden muss, spiegelt sich aber in den Kosten und dem Aufwand für die Herstellung der aktiv gekühlten Komponenten der entsprechenden Ladeeinrichtungen wider. Die DE 10 2016 107 409 A1 schlägt beispielsweise einen Steckverbinder mit einer aktiven Kühlung vor.

Die Dokumente DE 10 2016 105 308 A1 und US 10 535 940 B2 beschreiben Kontaktbaugruppen mit Kontaktelementen, an denen Wärmekapazitätselemente angeordnet sind. Diese Wärmekapazitätselemente sind, wie im Stand der Technik üblich, thermisch und auch elektrisch leitend mit den Kontaktelementen verbunden.

Die Wärmekapazitätselemente sind oftmals aus Materialien ausgebildet, die sowohl thermisch als auch elektrisch leitfähig sind. Oftmals werden hierfür Metalle oder graphitbasierende Werkstoffe verwendet.

Allerdings ist die Anbindung der aus dem Stand der Technik bekannten Wärmekapazitätselemente an die Kontaktelemente oft komplex, da die Kontaktelemente oft spezifische Geometrien zur Anbindung der Wärmekapazitätselemente aufweisen müssen. Auch ist der verfügbare Einbauraum in den elektrischen Steckverbindern oftmals begrenzt.

Aufgabe der vorliegenden Erfindung ist es, eine Kontaktbaugruppe mit einem Wärmekapazitätselement bereitzustellen, das Wärme, die durch einen Stromfluss durch das Kontaktelement entsteht, abführen kann und mit einer Vielzahl von unterschiedlich ausgestalteten Kontaktelementen verwendbar ist und dabei einen einfachen und platzsparenden Aufbau ermöglicht.

Diese Aufgabe wird durch einen Gegenstand mit den Merkmalen des Anspruchs 1 gelöst.

Demnach weist die Kontaktbaugruppe für einen elektrischen Steckverbinder zumindest ein Kontaktelement auf mit einem ersten Endbereich, der zum Verbinden mit einem korrespondierenden Steckverbinder ausgebildet ist und einem dem ersten Endbereich abgewandten zweiten Endbereich. Auch weist die Kontaktbaugruppe eine Lastleitung auf, wobei ein Endabschnitt eines isolierhüllenfreien Bereichs der Lastleitung verbindbar ist mit dem zweiten Endbereich des zumindest einen Kontaktelements. Weiterhin weist die Kontaktbaugruppe ein Wärmekapazitätselement auf, das zumindest bereichsweise an dem isolierhüllenfreien Bereich der Lastleitung anordenbar ist.

Das zumindest eine Kontaktelement kann einteilig oder mehrteilig aus einem leitfähigen Material ausgebildet sein und zumindest bereichsweise einen zylindrischen Querschnitt aufweisen. Der erste Endbereich kann als Kontaktstift oder als Kontaktbuchse ausgebildet sein, zum Verbinden mit einer korrespondierenden Kontaktbuchse oder einem korrespondierenden Kontaktstift eines korrespondierenden Steckverbinders. Der zweite Endbereich kann eine Aufnahme aufweisen, um die als Lastleitung ausgebildete elektrische Leitung anzuschließen. Beispielsweise kann das Kontaktelement ausgebildet sein, elektrische Ströme von größer 300 A, beispielsweise von bis zu 800 A zu übertragen.

Die Lastleitung kann hierin auch als Lastkabel oder nur als Kabel bezeichnet werden und einen Leiter aus einem elektrisch leitfähigen Werkstoff, wie beispielsweise Kupfer, aufweisen. Der Leiter kann als Massivleiter aus einem festen Strang ausgebildet sein, oder als Litzenleiter aus mehreren Litzen, die auch als Adern bezeichnet werden können, und in einem Verbund zusammengefasst sind. Der Leiterquerschnitt kann zumindest bereichsweise zylindrisch, quadratisch, rechteckig oder flach ausgebildet sein.

Der Leiter kann eine Isolierhülle aus einem Kunststoffmaterial aufweisen, wie beispielsweise aus PE (Polyethylen), PP (Polypropylen), PVC (Polyvinylchlorid), PUR (Polyurethan), usw.

Der isolierhüllenfreie Bereich der Lastleitung kann ein Bereich des Leiters sein, an dem zumindest bereichsweise keine Isolierhülle angeordnet ist, beziehungsweise die Isolierhülle vollständig oder bereichsweise entfernt wurde. Zur Herstellung einer elektrischen Verbindung ist ein Endabschnitt des isolierhüllenfreien Bereichs mit dem zweiten Endbereich des Kontaktelements verbindbar. Der Endabschnitt des isolierhüllenfreien Bereichs kann auch ein Endabschnitt, beziehungsweise Ende, des Leiters sein.

Das Wärmekapazitätselement kann blockförmig und einteilig aus einem Metall oder einem graphitbasierenden Material ausgebildet sein. Das Wärmekapazitätselement kann ein Phasenwechselmaterial aufweisen oder aus einem solchen ausgebildet sein. Das Wärmekapazitätselement kann aus einem einzigen Material oder auch aus mehreren unterschiedlichen Materialien ausgebildet sein. Das Wärmekapazitätselement ist ausgestaltet Wärme von dem Kontaktelement aufzunehmen. Das Wärmekapazitätselement ist thermisch über die Lastleitung mit dem Kontaktelement verbunden, sodass Wärme von dem Kontaktelement in das Wärmekapazitätselement einströmen und dort aufgenommen werden kann. Dies geht von dem Gedanken aus, an einem elektrischen Steckverbinder eine vergrößerte Wärmekapazität bereitzustellen, aufgrund derer das Erwärmen des elektrischen Steckverbinders, insbesondere des Kontaktelements des elektrischen Steckverbinders, zumindest verlangsamt werden kann. Dies kann beispielsweise bei einem elektrischen Steckverbinder für eine Ladeeinrichtung zum Laden eines Elektrofahrzeugs sinnvoll sein und wirkungsvoll ein übermäßiges Erwärmen an einer solchen Ladeeinrichtung verhindern.

Zum Anordnen des Wärmekapazitätselements an dem isolierhüllenfreien Bereich der Lastleitung, kann das Wärmekapazitätselement eine Verbindungsfläche aufweisen, die im Wesentlichen korrespondierend ausgestaltet ist zu einer Verbindungsfläche der Lastleitung, wie beispielsweise einer Leitergeometrie der Lastleitung. Das Wärmekapazitätselement kann beispielsweise mittels eines Halteelements, wie einem federnden Spannelement oder einem Klemmteil an der Lastleitung gehalten werden. Beispielsweise kann das Wärmkapazitätselement an der Lastleitung beabstandet zu dem Ende des Leiters gehalten werden, so dass das Wärmekapazitätselement das Kontaktelement nicht berührt, wenn der Endabschnitt des isolierhüllenfreien Bereichs der Lastleitung mit dem zweiten Endbereich des zumindest einen Kontaktelements verbunden ist. Eine derartige Anordnung, in der das Wärmekapazitätselement das Kontaktelement nicht berührt, kann auch als beabstandete Anordnung des Wärmekapazitätselements zu dem Kontaktelement bezeichnet werden. Beispielsweise kann in einer montierten Stellung der Kontaktbaugruppe ein Abstand von wenigen Millimetern bis wenigen Zentimetern, zwischen dem zweiten Endbereich des Kontaktelements und einer dem Kontaktelement zugewandten Seite des Wärmekapazitätselements liegen, wie beispielsweise ein Abstand in einem Bereich von 1 mm bis 2 cm.

In montierter Stellung ist der Endabschnitt des isolierhüllenfreien Bereichs der Lastleitung mit dem zweiten Endbereich des zumindest einen Kontaktelements verbunden und das Wärmekapazitätselement ist zumindest bereichsweise an dem isolierhüllenfreien Bereich der Lastleitung angeordnet.

Durch eine Anordnung des Wärmekapazitätselements an der Lastleitung kann effizient Wärme von dem Kontaktelement abgeführt werden, ohne dass das Wärmekapazitätselement mit dem Kontaktelement direkt verbunden ist.

In einer Ausgestaltung weist der isolierhüllenfreie Bereich der Lastleitung eine erste Verbindungsfläche auf und das Wärmekapazitätselement weist eine mit der ersten Verbindungsfläche korrespondierende, zweite Verbindungsfläche auf.

Durch zueinander korrespondierend ausgestaltete Verbindungsflächen kann eine stabile Verbindung zwischen Lastleitung und dem Wärmekapazitätselement geschaffen werden.

In einer Ausgestaltung sind die erste Verbindungsfläche und die zweite Verbindungsfläche flach oder gekrümmt ausgebildet.

In einer Ausgestaltung sind die erste Verbindungsfläche und die zweite Verbindungsfläche zylindrisch ausgebildet, wobei der isolierhüllenfreie Bereich der Lastleitung zumindest bereichsweise in einer Öffnung des Wärmekapazitätselements einliegt.

In einer Ausgestaltung weist die Kontaktbaugruppe ein Isolationsmaterial auf, das zwischen der ersten Verbindungsfläche und der zweiten Verbindungsfläche anordenbar ist, zum elektrischen Isolieren des Wärmekapazitätselements gegenüber der Lastleitung.

Das Isolationsmaterial ist elektrisch isolierend, aber thermisch leitfähig ausgestaltet. Hierfür weist das Isolationsmaterial vorzugsweise einen hinreichend hohen elektrischen Widerstand und einen hinreichend niedrigen thermischen Widerstand auf. Durch die Anordnung des Wärmekapazitätselements mittels eines Isolationsmaterials auf der Lastleitung kann entstehende Wärme gut abgeführt werden, bei zuverlässiger, durchschlagfester elektrischer Isolierung des Wärmekapazitätselements von der Lastleitung.

Beispielsweise kann das Isolationsmaterial als Folie, insbesondere als Polyimidfolie, ausgebildet sein, wobei die Folie eine Materialstärke in einem Bereich von 0,01 mm bis 0,1 mm, insbesondere in einem Bereich von 0,02 mm bis 0,08 mm aufweist. Beispielsweise kann das Isolationsmaterial eine Wärmeleitfähigkeit in einem Bereich von 0,1 W/(mK) bis 0,3 W/(mK), insbesondere von 0,2 W/(mK) aufweisen. Auch kann die Folie zumindest eine Klebeschicht aufweisen, wobei die Klebeschicht auf zumindest einer Seite der Folie, insbesondere vollflächig, angeordnet ist. Weiterhin kann die Folie schlauchförmig ausgebildet sein und sich zumindest bereichsweise um das Wärmekapazitätselement erstrecken.

Auch kann das Isolationsmaterial schichtförmig ausgebildet sein mit einer Wärmeleitfähigkeit von bis zu 5 W/(mK), und insbesondere ein Silikonkautschukmaterial aufweisen. Weiterhin kann das Isolationsmaterial als Spritzgussteil aus einem wärmeleitenden thermoplastischen Kunststoffmaterial, oder als eine Beschichtung, insbesondere als Lackierung oder Pulverbeschichtung ausgebildet sein.

In einer Ausgestaltung weist die Kontaktbaugruppe ein Halteelement auf, zum Halten des Wärmekapazitätselements an der Lastleitung.

Das Halteelement kann beispielsweise in einer montierten Stellung bandförmig um die Lastleitung und das Wärmekapazitätselement herum erstreckt sein. Das Halteelement kann beispielsweise aus einem elastisch federnden Material gefertigt sein und das Wärmekapazitätselement so mit der Lastleitung verspannen, dass das Wärmekapazitätselement unter elastischer Vorspannung an der Lastleitung anliegt. Das elastisch federnde Material kann beispielsweise eine Metallfeder oder ein Elastomer umfassen.

Das Halteelement kann somit als Spannmittel dienen und durch Bereitstellung einer hinreichenden Spannkraft eine dauerhafte Verbindung von Wärmekapazitätselement und Lastleitung ermöglichen. Hierdurch kann das Wärmekapazitätselement einen festen Sitz an der Lastleitung einnehmen. Weiterhin kann durch die Kraftbeaufschlagung des Wärmekapazitätselements ein fester Sitz selbst bei von außen einwirkenden Vibrationen gewährleistet werden.

In einer Ausgestaltung weist das Halteelement ein Klemmelement auf mit einer weiteren Verbindungsfläche.

Das Klemmelement kann mit dem Wärmekapazitätselement verbindbar sein, um im verbundenen Zustand mit dem Wärmekapazitätselement, die Lastleitung zwischen der zweiten Verbindungfläche des Wärmekapazitätselements und der weiteren Verbindungsfläche klemmend halten.

In einer Ausgestaltung ist die weitere Verbindungsfläche an einer der Lastleitung zugewandten Seite zumindest bereichsweise komplementär ausgestaltet zu dem isolierhüllenfreien Bereich der Lastleitung.

In einer Ausgestaltung weist das Halteelement zumindest ein Verbindungselement auf, insbesondere zumindest eine Schraube, um das Klemmelement mit dem Wärmekapazitätselement zu verbinden.

In einer Ausgestaltung weist das Wärmekapazitätselement einen massiven, quaderförmigen Körper auf.

Durch eine derartige Ausgestaltung kann eine große Wärmekapazität erreicht werden. Weiterhin können in einer Ausgestaltung an dem Wärmekapazitätselement auch Kühlrippen angeordnet sein, über die Wärme an die Umgebung abgegeben werden kann.

In einer Ausgestaltung weist das Wärmekapazitätselement ein Phasenwechselmaterial und/oder ein Metall, insbesondere Kupfer oder Aluminium, auf.

Das Wärmekapazitätselement kann aus einem metallenen Werkstoff, beispielsweise aus Kupfer oder Aluminium, hergestellt sein, um eine große Wärmekapazität und eine gute Wärmeleitfähigkeit zu erhalten.

Alternativ kann das Wärmekapazitätselement auch aus einem Phasenwechselmaterial hergestellt sein oder ein Phasenwechselmaterial aufweisen. Unter einem Phasenwechselmaterial wird hierin ein Material verstanden, das bei einem Phasenwechsel von fest zu flüssig große Mengen Wärme bei konstanter Temperatur und vergleichsweise kleinen Volumina speichern kann. Beispielsweise kann das Phasenwechselmaterial aus einem Materialverbund aus Graphit und Paraffin bestehen.

Durch den Einsatz eines Phasenwechselmaterials kann eine hohe volumenbezogene Energiespeicherdichte erreicht werden.

Weiterhin bezieht sich die Erfindung auf einen elektrischen Steckverbinder, insbesondere einen Ladesteckverbinder einer Ladeeinrichtung zum Laden eines Elektrofahrzeugs, aufweisend zumindest eine hierin beschriebene Kontaktbaugruppe.

In einer Ausgestaltung weist der elektrische Steckverbinder zwei Kontaktbaugruppen auf, wobei zwischen benachbarten Wärmekapazitätselementen eine Gehäusetrennwand aus einem elektrisch isolierenden Material angeordnet ist.

Alternativ oder zusätzlich zu einer Anordnung eines Isolationsmaterials zwischen der ersten Verbindungsfläche und der zweiten Verbindungsfläche kann eine Gehäusetrennwand aus einem elektrisch isolierenden Material zwischen benachbarten Wärmekapazitätselementen angeordnet sein, um benachbarte Kontaktbaugruppen gegeneinander elektrisch zu isolieren.

Der der Erfindung zugrunde liegende Gedanke soll nachfolgend anhand der in den Figuren dargestellten Ausführungsformen näher erläutert werden. Es zeigen:
- Figuren 1A - 1D: schematische Ansichten einer Kontaktbaugruppe gemäß einer ersten Ausführungsform;
- Figuren 2A - 2D: schematische Ansichten einer Kontaktbaugruppe gemäß einer zweiten Ausführungsform; und
- Figuren 3A - 3C: schematische Ansichten eines elektrischen Steckverbinders nach Ausführungsformen der Erfindung.

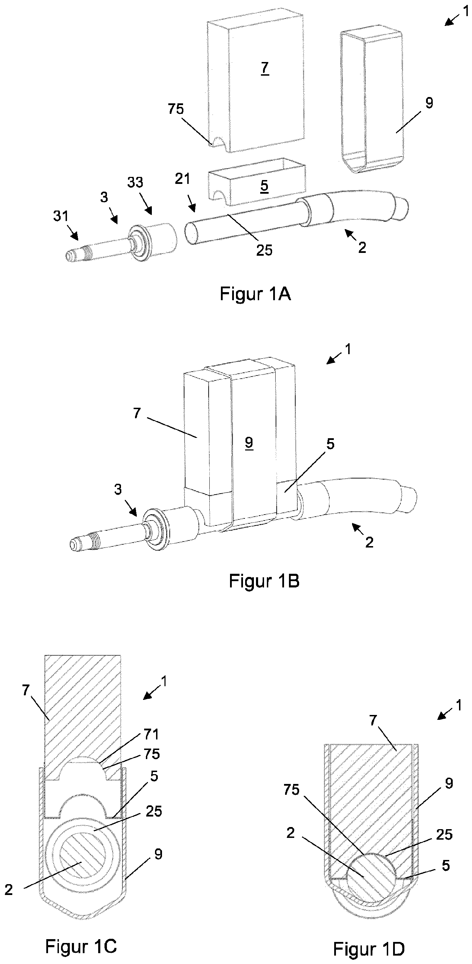

Die Figur 1A zeigt eine Explosionsansicht einer Kontaktbaugruppe 1, d.h. vor dem Anordnen des Wärmekapazitätselements 7 an dem isolierhüllenfreien Bereich 21 der Lastleitung 2 gemäß einer ersten Ausführungsform. Das gezeigte Kontaktelement 3 ist als Stiftkontakt ausgebildet und weist einen ersten Endbereich 31 auf, zum Verbinden mit einer korrespondierenden Buchse eines korrespondierenden Steckverbinders (nicht gezeigt). Der dem ersten Endbereich 31 abgewandte zweite Endbereich 33 ist verbindbar mit der Lastleitung 2.

Wie gezeigt, weist der isolierhüllenfreie Bereich 21 der Lastleitung 2 eine erste Verbindungsfläche 25 auf, die korrespondierend ausgestaltet ist zu der gezeigten zweiten Verbindungsfläche 75 des Wärmekapazitätselements 7. In der gezeigten Ausführungsform ist die erste Verbindungsfläche 25 zylindrisch ausgebildet, beziehungsweise wird durch die zylindrische Ausgestaltung des Leiters ausgebildet. In weiteren Ausführungsformen kann die erste Verbindungsfläche auch anderweitig ausgebildet sein, wie beispielweise flach ausgebildet sein. Beispielsweise kann eine flache Verbindungsfläche durch einen flachen Leiter realisiert werden. Weiterhin kann in Ausführungsformen ein Element mit der ersten Verbindungsfläche an den in der Figur 1A gezeigten isolierhüllenfreien Bereich 21 der Lastleitung 2 angeordnet sein.

In der gezeigten Ausführungsform ist weiterhin ein Isolationsmaterial 5 gezeigt, das zwischen dem Wärmekapazitätselement 7 und dem isolierhüllenfreien Bereich 21 der Lastleitung 2 anordenbar ist, zum elektrischen Isolieren des Wärmekapazitätselements 7 von der Lastleitung 2. In der in Figur 1B gezeigten montierten Stellung der Kontaktbaugruppe 1 steht eine erste Seite des Isolationsmaterials 5 mit dem isolierhüllenfreien Bereich 21 der Lastleitung 2 in Verbindung, beziehungsweise liegt auf diesem auf, und eine zweite Seite des Isolationsmaterial 5, die der ersten Seite gegenüberliegt, steht mit der Verbindungsfläche 75 des Wärmekapazitätselements 7 in Verbindung, beziehungsweise liegt auf dieser auf. In der gezeigten Ausführungsform ist das Isolationsmaterial 5 bereichsweise wannenförmig ausgebildet und in Erstreckungsrichtung des Isolationsmaterials 5 verlaufende und gegenüberliegende Randbereiche des Isolationsmaterials 5 sind in Richtung des Wärmekapazitätselementes 7 abgewinkelt, um hierdurch eine Sicherung vor Verrutschen und eine gute Isolation der Randbereiche des Wärmekapazitätselements 7 zu erreichen.

In der in den Figuren 1A und 1B gezeigten Ausführungsform ist auch ein Halteelement 9 dargestellt, das zumindest bereichsweise um die Lastleitung 2 und das Wärmekapazitätselement 7 anordenbar ist, zum Halten des Wärmekapazitätselements 7 an der Lastleitung 2. In der gezeigten Ausführungsform ist das Halteelement 9 bandförmig als endlos-Band aus einem elastisch federnden Material ausgestaltet, das über das Wärmekapazitätselement 7 und die Lastleitung in Verlaufsrichtung des Kontaktelements 3, beziehungsweise der Lastleitung 2, geschoben werden kann, um das Wärmekapazitätselement 7 mit der Lastleitung 2 zu verspannen, sodass das Wärmekapazitätselement 7 unter elastischer Vorspannung an der Lastleitung 2 anliegt. In der gezeigten Ausführungsform ist die Geometrie des Halteelements 9 bereits an die zu umgebenden Außenflächen des Wärmekapazitätselements 7 und der Lastleitung 2 angepasst.

In den Figuren 1C und 1D sind Schnittansichten durch die in den Figuren 1A und 1B gezeigte Ausführungsform gezeigt. Die Figur 1C zeigt eine Schnittansicht in Verlaufsrichtung durch die in Figur 1A dargestellte Explosionsansicht der Kontaktbaugruppe 1. In der gezeigten Ausführungsform ist die Verbindungsfläche 25 an der Lastleitung 2 und die Verbindungsfläche 75 an dem Wärmekapazitätselement 7 jeweils miteinander korrespondierend, zylindrisch, ausgeführt. Weiterhin ist gezeigt, dass das Wärmekapazitätselement 7 an der Lastleitung 2 über das Halteelement 9 angeordnet wird.

Auch sind in der in Figur 1C gezeigten Ausführungsform die erste Verbindungsfläche 25 und die zweite Verbindungsfläche 75 zylindrisch ausgebildet, wobei der isolierhüllenfreie Bereich 21 der Lastleitung 2 zumindest bereichsweise in einer Öffnung 71 des Wärmekapazitätselements 7 einbringbar ist.

In der Figur 1D ist eine Schnittansicht durch die in der Figur 1B gezeigten Kontaktbaugruppe 1 in montierter Stellung gezeigt.

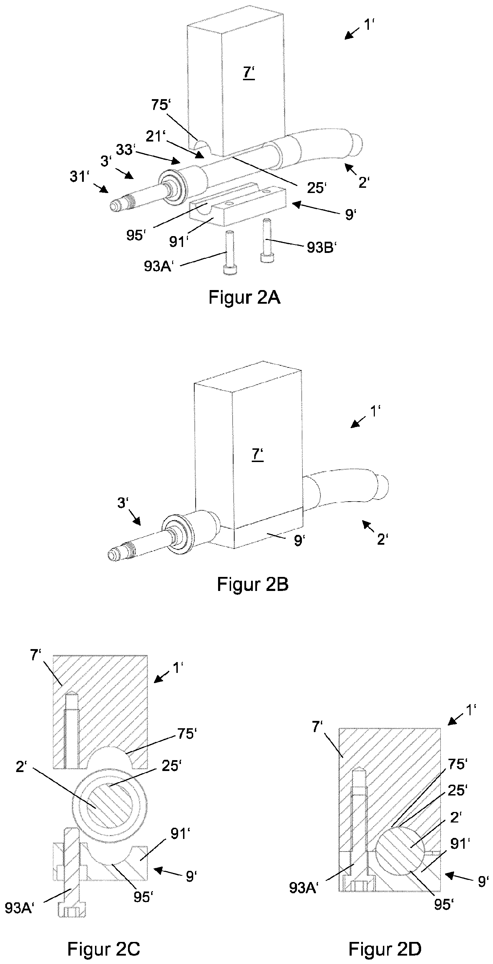

Die Figur 2A zeigt eine Explosionsansicht einer Kontaktbaugruppe 1' gemäß einer zweiten Ausführungsform.

Die gezeigte Kontaktbaugruppe 1' unterscheidet sich von der zuvor in den Figuren 1A bis 1D gezeigten Kontaktbaugruppe 1 dadurch, dass das Halteelement 9' ein Klemmelement 91' mit einer weiteren Verbindungsfläche 95' aufweist. Das Klemmelement 91' in der gezeigten Ausführungsform ist aus dem gleichen Material ausgebildet, wie das Wärmekapazitätselement 7. Die weitere Verbindungsfläche 95' ist, wie gezeigt, an einer der Lastleitung 2' zugewandten Seite zumindest bereichsweise komplementär ausgestaltet zu dem isolierhüllenfreien Bereich 21' der Lastleitung 2'.

In der gezeigten Ausführungsform weist das Halteelement 9` zwei als Schrauben ausgestaltete Verbindungselemente 93A', 93B' auf, um das Klemmelement 91' mit dem Wärmekapazitätselement 7' zu verbinden.

In der in Figur 2B gezeigten montierten Stellung der Kontaktbaugruppe 1' ist das Halteelement 9' mit dem Wärmekapazitätselement 7' verbunden und hält, beziehungsweise klemmt, die Lastleitung 2' zwischen der Verbindungfläche des Wärmekapazitätselements 7' und der weiteren Verbindungsfläche des Klemmelements.

In den Figuren 2C und 2D sind Schnittansichten durch die in den Figuren 2A und 2B gezeigte Ausführungsform gezeigt. Die Figur 2C zeigt eine Schnittansicht in Verlaufsrichtung durch die in Figur 2A dargestellte Explosionsansicht der Kontaktbaugruppe 1'. In der gezeigten Ausführungsform sind die Verbindungsfläche 25' an der Lastleitung 2' und die Verbindungsfläche 75' an dem Wärmekapazitätselement 7' jeweils miteinander korrespondierend, zylindrisch, ausgeführt. Weiterhin ist gezeigt, dass die weitere Verbindungsfläche 95' des Halteelements 91' an einer der Lastleitung 2' zugewandten Seite zumindest bereichsweise komplementär ausgestaltet ist zu dem isolierhüllenfreien Bereich 21' der Lastleitung 2'.

In der Figur 2D ist eine Schnittansicht durch die in der Figur 2B gezeigten Kontaktbaugruppe 1' in montierter Stellung gezeigt.

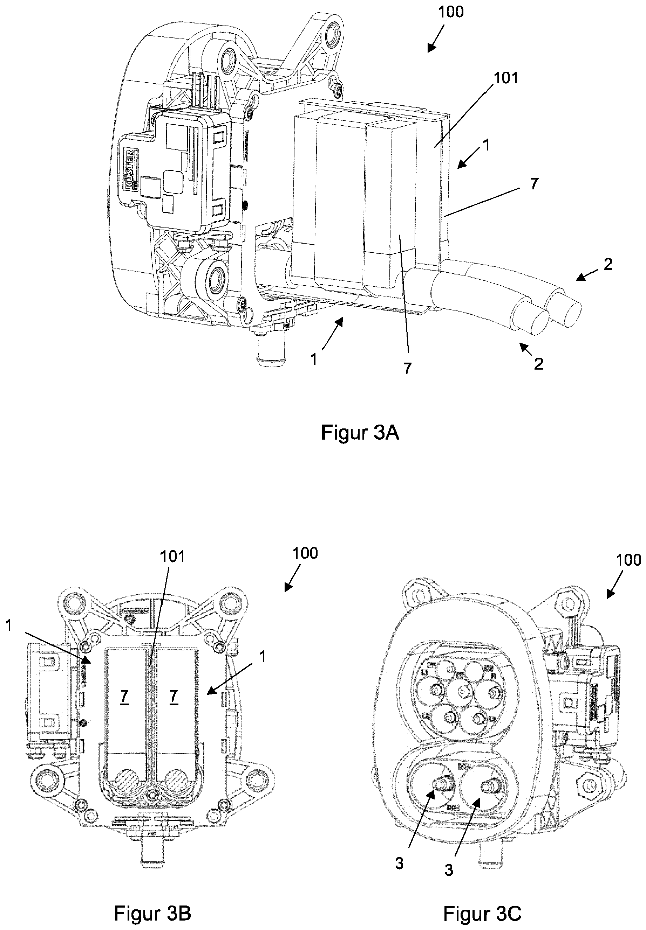

Die Figuren 3A bis 3C zeigen schematische Ansichten eines elektrischen Steckverbinders 100 mit Kontaktbaugruppen 1, 1 nach der in den Figuren 1A - 1D gezeigten ersten Ausführungsformen der Erfindung. Der Steckverbinder 100 ist als Ladesteckverbinder einer Ladeeinrichtung zum Laden eines Elektrofahrzeugs dargestellt. Im Speziellen ist der Ladesteckverbinder als Combined Charging System, CCS, Stecker, der auch als Combo-Stecker bezeichnet werden kann, dargestellt.

Wie gezeigt ist der Ladesteckverbinder in zwei Bereiche eingeteilt: Der obere Teil entspricht einem sogenannten Typ-2-Anschluss. Der untere Teil dient für das elektrische Laden mit Gleichstrom.

In dem unteren Teil sind in der gezeigten Ausführungsform, zwei einpolige Kontaktbaugruppen 1 gemäß der in Figuren 1A - 1D dargestellten Ausführungsform verwendet. Weiterhin ist in den Figuren 3A und 3B eine Gehäusetrennwand 101 aus einem elektrisch isolierenden Material gezeigt, die zwischen benachbarten Wärmekapazitätselementen 7, 7 angeordnet ist.

### Bezugszeichenliste

- 1, 1': Kontaktbaugruppe
- 2, 2': Lastleitung
- 21, 21': Isolierhüllenfreier Bereich
- 3, 3`: Kontaktelement
- 31, 31': Erster Endbereich
- 33, 33': Zweiter Endbereich
- 25, 25', 75, 95': Verbindungsfläche
- 5: Isolationsmaterial
- 7, 7': Wärmekapazitätselement
- 71: Öffnung
- 9, 9`: Halteelement
- 91': Klemmelement
- 93A', 93B`: Verbindungselement

- 100: Elektrischer Steckverbinder
- 101: Gehäusetrennwand

## Patentansprüche

1. Kontaktbaugruppe für einen elektrischen Steckverbinder (100), aufweisend:
zumindest ein Kontaktelement (3, 3') mit einem ersten Endbereich (31, 31'), der zum Verbinden mit einem korrespondierenden Steckverbinder ausgebildet ist und einem dem ersten Endbereich (31, 31') abgewandten zweiten Endbereich (33, 33`); und
eine Lastleitung (2, 2`), wobei ein Endabschnitt eines isolierhüllenfreien Bereichs (21, 21') der Lastleitung (2, 2') verbindbar ist mit dem zweiten Endbereich (33, 33') des zumindest einen Kontaktelements (3, 3'), **gekennzeichnet durch**
ein Wärmekapazitätselement (7, 7`), das zumindest bereichsweise an dem isolierhüllenfreien Bereich (21, 21') der Lastleitung (2, 2') anordenbar ist.

2. Kontaktbaugruppe nach Anspruch 1, **dadurch gekennzeichnet, dass** der isolierhüllenfreie Bereich (21, 21') der Lastleitung (2, 2`) eine erste Verbindungsfläche (25, 25') aufweist und das Wärmekapazitätselement (7, 7') eine mit der ersten Verbindungsfläche (25, 25`) korrespondierende, zweite Verbindungsfläche (75, 75`) aufweist.

3. Kontaktbaugruppe nach Anspruch 2, **dadurch gekennzeichnet, dass** die erste Verbindungsfläche (25, 25`) und die zweite Verbindungsfläche (75, 75') flach oder gekrümmt ausgebildet sind.

4. Kontaktbaugruppe nach Anspruch 2 oder 3, **dadurch gekennzeichnet, dass** die erste Verbindungsfläche (25) und die zweite Verbindungsfläche (75) zylindrisch ausgebildet sind, wobei der isolierhüllenfreie Bereich (21) der Lastleitung (2) zumindest bereichsweise in einer Öffnung (71) des Wärmekapazitätselements (7) einliegt.

5. Kontaktbaugruppe nach einem der vorangehenden Ansprüche, **gekennzeichnet durch** ein Isolationsmaterial (5), das zwischen der ersten Verbindungsfläche (25) und der zweiten Verbindungsfläche (75) anordenbar ist, zum elektrischen Isolieren des Wärmekapazitätselements (7) von der Lastleitung (2).

6. Kontaktbaugruppe nach einem der vorangehenden Ansprüche, **gekennzeichnet durch** ein Halteelement (9, 9`), zum Halten des Wärmekapazitätselements (7, 7') an der Lastleitung (2, 2').

7. Kontaktbaugruppe nach Anspruch 6, **dadurch gekennzeichnet, dass** das Haltelement (9) in montierter Stellung bandförmig um die Lastleitung (2) und das Wärmekapazitätselement (7) herum erstreckt ist.

8. Kontaktbaugruppe nach Anspruch 6 oder 7, **dadurch gekennzeichnet, dass** das Haltelement (9) aus einem elastisch federnden Material ausgebildet ist.

9. Kontaktbaugruppe nach Anspruch 6, **dadurch gekennzeichnet, dass** das Halteelement (9`) ein Klemmelement (91') aufweist mit einer weiteren Verbindungsfläche (95`).

10. Kontaktbaugruppe nach Anspruch 9, **dadurch gekennzeichnet, dass** die weitere Verbindungsfläche (95') an einer der Lastleitung (2') zugewandten Seite zumindest bereichsweise komplementär ausgestaltet ist zu dem isolierhüllenfreien Bereich (21') der Lastleitung (2').

11. Kontaktbaugruppe nach einem der Ansprüche 9 oder 10, **dadurch gekennzeichnet, dass** das Halteelement (9') zumindest ein Verbindungselement (93A`, 93B`) aufweist, insbesondere zumindest eine Schraube, um das Klemmelement (91') mit dem Wärmekapazitätselement (7`) zu verbinden.

12. Kontaktbaugruppe nach einem der vorangehenden Ansprüche, **dadurch gekennzeichnet, dass** das Wärmekapazitätselement (7, 7') einen massiven, quaderförmigen Körper aufweist.

13. Kontaktbaugruppe nach einem der vorangehenden Ansprüche, **dadurch gekennzeichnet, dass** das Wärmekapazitätselement (7, 7`) ein Phasenwechselmaterial oder ein Metall, insbesondere Kupfer oder Aluminium, aufweist.

14. Elektrischer Steckverbinder, insbesondere ein Ladesteckverbinder einer Ladeeinrichtung zum Laden eines Elektrofahrzeugs, aufweisend zumindest einen Kontaktbaugruppe (1, 1') nach einem der vorangehenden Ansprüche.

15. Elektrischer Steckverbinder nach Anspruch 14, **gekennzeichnet durch** zwei Kontaktbaugruppen (1, 1), wobei zwischen benachbarten Wärmekapazitätselementen (7, 7) eine Gehäusetrennwand (101) aus einem elektrisch isolierenden Material angeordnet ist.
